# EUROPÄISCHE PATENTSCHRIFT

(11) **EP 1 362 413 B1**
(45) Veröffentlichungstag und Bekanntmachung des Hinweises auf die Patenterteilung: **14.07.2004**
(21) Anmeldenummer: 02716631.3
(22) Anmeldetag: 20.02.2002
(51) Int. Cl.: H03C 3/09

(54) **ABGLEICHVERFAHREN UND ABGLEICHEINRICHTUNG FÜR PLL-SCHALTUNG ZUR ZWEI-PUNKT-MODULATION**
COMPENSATION METHOD AND COMPENSATING DEVICE FOR A PLL CIRCUIT FOR TWO-POINT MODULATION
PROCEDE D'EQUILIBRAGE ET DISPOSITIF D'EQUILIBRAGE POUR CIRCUIT A BOUCLE A VERROUILLAGE DE PHASE POUR MODULATION A DEUX ETATS

(30) Priorität: 22.02.2001 DE 10108636
(43) Veröffentlichungstag der Anmeldung: 19.11.2003
(73) Patentinhaber: Infineon Technologies AG, 81669 München (DE)
(72) Erfinder: HAMMES, Markus, 46539 Dinslaken (DE); VAN WAASEN, Stefan, 47178 Duisburg (DE)
(74) Vertreter: Lange, Thomas, Dr.
(86) Internationale Anmeldenummer: PCT/DE2002/000727
(87) Internationale Veröffentlichungsnummer: WO 2002/067428

(56) Entgegenhaltungen:
- EP-A- 0 961 412
- EP-A- 1 079 514
- GB-A- 2 344 006
- US-A- 5 207 491
- US-A- 5 483 203

## Beschreibung

Die Erfindung betrifft ein Abgleichverfahren für eine nach dem Prinzip der Zwei-Punkt-Modulation arbeitende PLL-Schaltung sowie eine derartige, für das Einprägen eines analogen und eines digitalen Modulationssignals ausgelegte PLL-Schaltung.

Eine aufwandsgünstige Realisierung eines Senderkonzepts für Transceiver in Mobilfunksystemen bieten Sender, bei welchen eine PLL (Phase-Locked-Loop: Nachlaufsynchronisations-) Schaltung als Frequenzsynthesizer eingesetzt und zur Frequenz- bzw. Phasenmodulation eines hochfrequenten Signals genutzt wird.

Das Einprägen des Modulationssignals in die PLL-Schaltung erfolgt üblicherweise über einen im Rückkoppelzweig der PL-Schleife enthaltenen Frequenzteiler. Dabei wird ein digitales Modulationssignal verwendet und zum fortwährenden Umprogrammieren des digitalen Frequenzteilers eingesetzt. Diese Form der Modulation, die auch als Ein-Punkt-Modulation bezeichnet wird, ist Stand der Technik und beispielsweise in den U.S.-Patenten 4,965,531; 6,008,703 und 6,044,124 beschrieben.

Um ein geringes Rauschen der PLL-Schaltung zu erreichen, wird die Bandbreite der Schaltung deutlich kleiner ausgelegt, als es für die Übertragung der modulierten Daten erforderlich ist. Aus diesem Grund wird zusätzlich zu der rein digitalen Modulation eine analoge Modulation zur Kompensation der beschränkten Bandbreite eingesetzt. Das gleichzeitige Einprägen eines digitalen und eines analogen Modulationssignals in eine PLL-Schaltung wird als Zwei-Punkt-Modulation bezeichnet.

In der deutschen Offenlegungsschrift DE 199 29 167 A1 ist ein Zwei-Punkt-Modulator sowie ein Verfahren zur Zwei-Punkt-Phasen- oder Frequenzmodulation mit einer PLL-Schaltung beschrieben. Ein digitales Modulationssignal, das zur Programmierung des Frequenzteilers eingesetzt wird, wird darüber hinaus mittels eines Digital-Analog-Umsetzers in ein analoges Modulationssignal gewandelt, welches dann an einem an geeigneter Stelle befindlichen Summationspunkt in die PL-Schleife eingekoppelt wird. Die beiden Modulationssignale überlagern sich am Ausgang der PLL und man erhält auf diese Weise ein frequenzunabhängiges Übertragungsverhalten der Schleife.

Ein weiterer Zwei-Punkt-Modulator ist aus dem Dokument EP-A-0 961 412 bekannt, welches den nächstliegenden Stand der Technik darstellt.

Eine Schwierigkeit bei der Zwei-Punkt-Modulation besteht darin, dass neben der zeitlichen Gleichphasigkeit ein hohes Maß an Übereinstimmung der Amplituden der beiden verwendeten Modulationssignale benötigt wird. Aufgrund von Herstellungstoleranzen der Komponenten für die analoge Modulation treten jedoch stets Schwankungen in der Modulationssteilheit sowie der Amplitudenhöhe der Modulation auf. Aus diesem Grund ist es erforderlich, nach der Herstellung der PLL-Schaltung einen Amplitudenabgleich zwischen der analogen und der digitalen Modulation vorzunehmen.

Sollen darüber hinaus noch Temperatureinflüsse berücksichtigt werden, muss ein solcher Abgleich vor jedem Sendevorgang erneut durchgeführt werden.

Ein bekanntes Verfahren zum Abgleichen einer PLL-Schaltung besteht darin, die Zwei-Punkt-Modulation der Schaltung im eingeschwungenen Zustand aufzuprägen und mit einem externen Mess-Empfänger das ausgesendete Signal zu empfangen, zu demodulieren und in Abhängigkeit von dem Demodulationsergebnis einen Abgleich der digitalen und analogen Modulationssignale vorzunehmen. Aufgrund des nicht-linearen Verhaltens des schwingungserzeugenden Glieds (es handelt sich um einen spannungsgesteuerten Oszillator oder VCO: Voltage Controlled Oscillator) der PLL-Schaltung hinsichtlich der Frequenz als Funktion der Steuerspannung muss dieser Abgleich jedoch für jeden Kanal vorgenommen werden, was bei vielen Kanälen eine entsprechend lange Messdauer bedeutet. Darüber hinaus müssen die Abgleichinformationen in einem Speicher abgelegt werden, und nachteilig ist ferner, dass der Einfluß von Temperaturänderungen bei diesem Verfahren nicht berücksichtigt wird.

Eine weitere Möglichkeit besteht darin, den Empfang und die Demodulation des von der PLL-Schaltung erzeugten Signals durch das Empfangsteil des Transceivers vorzunehmen. Hierfür wäre allerdings eine vollständige zweite PLL-Schaltung im Empfänger erforderlich, wodurch sich der Schaltungsaufwand in nachteiliger Weise wesentlich erhöht.

Der Erfindung liegt die Aufgabe zugrunde, ein Abgleichverfahren für eine nach dem Prinzip der Zwei-Punkt-Modulation arbeitende PLL-Schaltung anzugeben, welches aufwandsarm einen schnellen Amplitudenabgleich ermöglicht und insbesondere die Berücksichtigung von Temperatureinflüssen erlaubt. Ferner zielt die Erfindung darauf ab, eine PLL-Schaltung mit einer Abgleicheinheit anzugeben, welche aufwandsarm realisierbar ist und einen schnellen und problemfreien Amplitudenabgleich der Modulationssignale ermöglicht.

Die der Erfindung zugrunde liegende Aufgabenstellung wird durch die Merkmal der unabhängigen Patentansprüche gelöst.

Gemäß der Erfindung wird die PLL-Schaltung zunächst ohne Einprägen einer Modulation betrieben, d.h. auf eine gewünschte Frequenz eingeschwungen. Anschließend wird ein analoges und ein digitales Modulationssignal in die eingeschwungene PLL-Schaltung eingeprägt. Sofern diese Signale nicht identische Amplituden aufweisen (in diesem Fall wären die Modulationshübe bereits abgeglichen), tritt dabei eine PLL-Regelabweichung auf. Es wird dann ein für die PLL-Regelabweichung charakteristisches Signal aus der PLL-Schaltung ausgekoppelt. Der Modulationshub des analogen Modulationssignals wird nun in der Weise geändert, dass das für die PLL-Regelabweichung charakteristische Signal den gleichen Wert wie vor dem Einprägen der analogen und digitalen Modulationssignale aufweist.

Bei dieser Art des Abgleichs entfällt eine Demodulation des von der PLL-Schaltung erzeugten Ausgangssignals, weil zu Abgleichzwecken auf das für die Regelabweichung in der PLL-Schaltung charakteristische Signal zurückgegriffen wird. Demzufolge ist das Vorsehen eines internen oder externen Demodulators nicht erforderlich, wodurch der Schaltungsaufwand gering gehalten und eine hohe Praktikabilität des erfindungsgemäßen Abgleichverfahrens erreicht wird.

Ein vorteilhaftes Ausführungsbeispiel des erfindungsgemäßen Verfahrens kennzeichnet sich dadurch, dass das für die Regelabweichung der PLL-Schaltung charakteristische Signal ein Spannungssignal ist, welches über eine Ladungspumpe und ein Tiefpassfilter aus der PLL-Schaltung ausgekoppelt wird. Durch eine geeignete Auslegung dieser Komponenten kann eine ausreichend hohe Empfindlichkeit des Abgleichverfahrens erreicht werden.

Zur Änderung des Modulationshubs des analogen Modulationsignals werden vorzugsweise die folgenden Schritte durchgeführt: Es wird das für die Regelabweichung charakteristische Signal mit einem Referenzsignal eines festen Wertes verglichen, wobei ein Vergleichssignal erzeugt wird. Das Vergleichssignal wird vor und nach dem Einprägen der analogen und digitalen Modulation ausgewertet. Auf der Basis des Auswerteergebnisses wird der Modulationshub des analogen Modulationssignals geändert.

Ein vorteilhaftes Ausführungsbeispiel des erfindungsgemäßen Verfahrens kennzeichnet sich dadurch, dass zur Bereitstellung des Referenzsignals die PLL-Schaltung im deaktivierten Zustand auf eine gewünschte Kanalmittenfrequenz eingestellt (d.h. programmiert) wird, die PLL-Schaltung aktiviert wird und dabei einschwingt, und beim Einschwingvorgang aus dem für die Regelabweichung der PLL-Schaltung charakteristischen Signal das Referenzsignal erzeugt wird. Bei diesem Ausführungsbeispiel wird das für den Abgleich benötigte Referenzsignal gewissermaßen mit Hilfe der PLL-Schaltung selber erzeugt.

Ein alternatives, ebenfalls vorteilhaftes Ausführungsbeispiel kennzeichnet sich dadurch, dass ein vorgegebenes Referenzsignal extern bereitgestellt wird. Das vorgegebene Referenzsignal kann für alle Kanalmittenfrequenzen identisch sein oder es ist auch möglich, ein von der gewünschten Kanalmittenfrequenz abhängiges Referenzsignal vorzusehen.

Der erfindungsgemäßen PLL-Schaltung ist eine Abgleicheinheit zugeordnet, welche ein Mittel zum Auskoppeln eines für die PLL-Regelabweichung charakteristischen Signals aus der PLL-Schaltung sowie ein Mittel zum Auswerten des für die Regelabweichung charakteristischen Signals sowie ein Mittel zum Ändern des Modulationshubes des analogen Modulationssignals in Abhängigkeit von dem Auswerteergebnis umfasst.

Eine schaltungstechnisch einfache und kostengünstige Realisierung des Mittels zum Auskoppeln des für die PLL-Regelabweichung charakteristischen Signals aus der PLL-Schaltung umfasst eine Ladungspumpe und ein der Ladungspumpe nachgeschaltetes Tiefpassfilter.

Das Mittel zum Auswerten des charakteristischen Signals umfasst vorzugsweise ein Mittel zum Vergleichen des für die Regelabweichung charakteristischen Signals mit einem Referenzsignal eines festen Wertes, wobei ein Vergleichssignal erzeugt wird, und ein Mittel zum Auswerten des Vergleichssignals vor und nach dem Einprägen der analogen und digitalen Modulation. Das Referenzsignal sollte dabei so gewählt werden, dass das vergleichsmittel (Komparator) im Bereich maximaler Empfindlichkeit betrieben wird.

Weitere vorteilhafte Ausgestaltungen der Erfindung sind in den Unteransprüchen angegeben.

Die Erfindung wird nachfolgend anhand von zwei Ausführungsbeispielen unter Bezugnahme auf die Zeichnung erläutert. In dieser zeigt:
- Fig. 1: eine nach dem Prinzip der Zwei-Punkt-Modulation arbeitende PLL-Schaltungsanordnung mit einer Abgleicheinheit gemäß der Erfindung;
- Fig. 2: ein erstes Ausführungsbeispiel der in Fig. 1 gezeigten Abgleicheinheit;
- Fig. 3: ein zweites Ausführungsbeispiel der in Fig. 1 gezeigten Abgleicheinheit;
- Fig. 4: eine Schaltbilddarstellung einer in der Abgleicheinheit verwendeten Ladungspumpe; und
- Fig. 5: eine Schaltbilddarstellung eines in der Abgleicheinheit eingesetzten Tiefpassfilters.

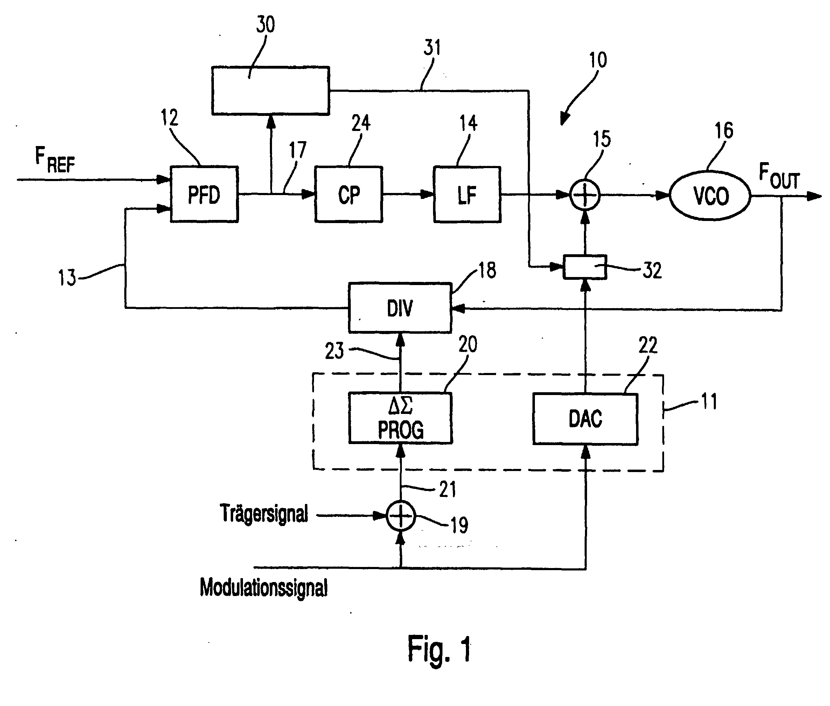

Fig. 1 zeigt eine nach dem Prinzip der Zwei-Punkt-Modulation arbeitende PLL-Schaltung 10, welche mit einer Abgleicheinheit 30 gekoppelt ist.

Die PLL-Schaltung 10 weist in ihrem Signalpfad gemäß üblicher Bauweise einen Phasendetektor PFD (Phase Frequency Detector) 12, eine Ladungspumpe CP (Charge Pump) 24, ein Schleifenfilter LF (Loop Filter) 14, einen Summationspunkt 15 und einen spannungsgesteuerten Oszillator VCO (Voltage Controlled Oscillator) 16 auf.

Der VCO 16 stellt das schwingungserzeugende Glied der PLL-Schaltung 10 dar und liefert als Ausgangssignal der PLL-Schaltung 10 ein Signal der Frequenz F_{OUT}.

Die PLL-Regelschleife 10 wird durch einen Rückkoppelzweig geschlossen, welcher das Ausgangssignal des VCO 16 über einen programmierbaren Frequenzteiler DIV (Divider) 18 zu dem Frequenzdetektor 12 zurückführt.

Die Wirkungsweise der PLL-Schaltung als Frequenzsynthesizer bei einer Zwei-Punkt-Modulation ist bekannt. Bei der Zwei-Punkt-Modulation werden der PLL-Schaltung 10 ein digitales und ein analoges Modulationssignal eingeprägt. Fig. 1 zeigt ein Beispiel einer Modulationsschaltung 11, mittels welcher die beiden Modulationssignale aufbereitete und der PLL-Schaltung 10 zugeleitet werden. Die hier beispielhaft dargestellte Modulationsschaltung 11 umfasst eine Programmiereinrichtung 20 und einen Digital-Analog-Umsetzer DAC (Digitalto-Analog-Converter) 22. Ein Modulationssignal wird an einem Summationspunkt 19 auf ein der PLL-Frequenzsynthese zugrunde liegendes Trägersignal addiert und das sich ergebende addierte Signal 21 wird der Programmiereinrichtung 20 zugeführt. Ferner wird das Modulationssignal auch dem Digital-Analog-Umsetzer 22 zugeführt.

Die Programmiereinrichtung 20, bei der es sich beispielsweise um eine einen Sigma-Delta Modulator enthaltende Programmiereinrichtung 20 handeln kann, erzeugt ein Steuersignal 23, das dem programmierbaren Frequenzteiler 18 zugeführt wird. Das Steuersignal 23 ist ein digitales Signal, welches ein Teilerverhältnis 1:N angibt. N ist eine ganze Zahl und unterliegt aufgrund des Modulationssignals ständigen Änderungen, wodurch der programmierbare Freuenzteiler 18 fortwährend umprogrammiert wird. Durch das fortwährende Umprogrammieren des Frequenzteilers 18 wird die digitale Modulation in die PLL-Schaltung 10 eingeprägt.

Bei dem Freuquenzteiler 18 kann es sich beispielsweise um einen sogenannten Fraktional-N Frequenzteiler handelt. Fraktional-N Frequenzteiler ermöglichen eine Frequenzteilung auch durch eine nicht ganze Zahl (sog. fraktionale Synthesetechnik). Die fraktionale Synthesetechnik ist vorteilhaft, weil die bei einer ganzzahligen Teilung auftretenden Störungen durch Seitenlinien im Spektrum des Ausgangssignals vermieden werden.

Die analoge Modulation wird über den Digital-Analog-Umsetzer 22 und den Summationspunkt 15 vorgenommen. Der Digital-Analog-Umsetzer 22 erzeugt ein analoges Ausgangssignal, welches mittels des Summationspunktes 15 dem Steuersignal für den VCO 16 überlagert wird.

Es wird darauf hingewiesen, dass die Modulationsschaltung 11 auch in anderer Art und Weise realisiert sein kann. Beispielsweise kann bei Verwendung eines analogen Modulationssignals der Digital-Analog-Umsetzer 22 entfallen und statt dessen im digitalen Modulationszweig eine entsprechende Signalwandlung vorgenommen werden. Für die Erfindung von Bedeutung ist lediglich, dass bei der Zwei-Punkt-Modulation eines der Modulationssignale ein analoges Signal und das andere Modulationssignal ein digitales Signal ist.

Die Arbeitsweise der PLL-Schaltung im eingeschwungenen Zustand ist bekannt und wird im folgenden kurz erläutert:

Der Frequenzteiler DIV 18 gibt ein Frequenzteilersignal 13 aus, welches in der bereits beschriebenen Weise durch Frequenzteilung aus dem Ausgangssignal der PLL-Schaltung 10 erzeugt wird. Der Phasendetektor PFD 12 vergleicht die Phasen der beiden erhaltenen Signale und erzeugt ein Steuersignal 17, welches der Phasendifferenz der beiden erhaltenen Signale entspricht. Das Steuersignal 17 wird zur Ansteuerung der Ladungspumpe CP 24 verwendet. Ein in Abhängigkeit von dem Steuersignal 17 in der Ladungspumpe 24 generierter Strom wird zum Aufladen des Schleifenfilters LF 14 eingesetzt. Da das Schleifenfiler LF 14 ein Tiefpassfilter ist, werden höherfrequente Signalanteile auf diese Weise geglättet. Der Ausgang des Schleifenfilters LF 14 wird dann nach Hinzufügung der analogen Modulation am Summationspunkt 15 zur Steuerung des Oszillators 16 verwendet.

Da das analoge Modulationssignal im Gegensatz zu dem digitalen Modulationssignal 23, welches aufgrund seiner diskreten Natur keine Toleranzen aufweist, drift- und toleranzbehaftet ist, ist es erforderlich, die beiden Modulationssignale hinsichtlich ihrer Amplituden anzugleichen. Zu diesem Zweck ist die PLL-Schaltung 10 mit einer Abgleicheinheit 30 gekoppelt, deren Funktion und Bauweise im folgenden noch näher erläutert wird. Die Abgleicheinheit 30 gibt ein Steuersignal 31 aus, welches einer Einrichtung 32 zur Beeinflussung der Amplitude des analogen Modulationssignals zugeführt wird.

Zum besseren Verständnis wird das Wirkungsprinzip der 2-Punkt-Modulationstechnik kurz erläutert: Im Betrieb soll beim Einprägen der Modulation in die PLL-Regelschleife 12, 24, 14, 16, 18 die geschlossene Regelschleife keine Reaktion auf die Modulation zeigen. Dies wird dadurch erreicht, dass die analog am Summationspunkt 15 aufgeprägte analoge Modulation durch eine entsprechend entgegengesetzt wirkende Änderung der Teilerfaktoren des Frequenzteilers 18, bewirkt durch die digitale Modulation, kompensiert wird. Wird also durch die analoge Modulation die Ausgangsfrequenz F_{OUT} des VCO erhöht, muss gleichzeitig der Teilerfaktor im selben Maße (durch die digitale Modulation) erhöht werden, so dass die Ausgangsfrequenz des Frequenzteilers 18 (das Frequenzteilersignal 13) unverändert von der Modulation bleibt. Analog muss bei einer Erniedrigung der Ausgangsfrequenz F_{OUT} der Teilerfaktor entsprechend erniedrigt werden. D.h., bei exakter Übereinstimmung von analogem und digitalem Modulationshub verhält sich die geschlossene Schleife wie eine geöffnete Schleife. Stimmen die Modulationshübe nicht überein, so regelt die PLL-Regelschleife die Abweichung aus. Ein Maß für die Ungleichheit der Modulationshübe ist die am Ausgang von dem Schleifenfilter LF 14 auftretende Spannungsänderung beim Hinzuschalten der Modulationen. Diese Spannungsänderung ist im allgemeinen jedoch sehr klein (einige mV). Die Erfindung beruht nun auf der Idee, unter Verwendung eines Parallelpfades mit gleicher Wirkung diese Spannungsänderung in besser auszuwertender Größenordnung (z.B. einige 100 mV) zur Verfügung zu stellen, wobei gleiche Bedingungen gelten: Keine Regelwirkung in der PLL-Regelschleife bedeutet keine Aktivität am Phasendetektor PFD 12 und somit keine Spannungsänderung am Ausgang des Parallelpfads.

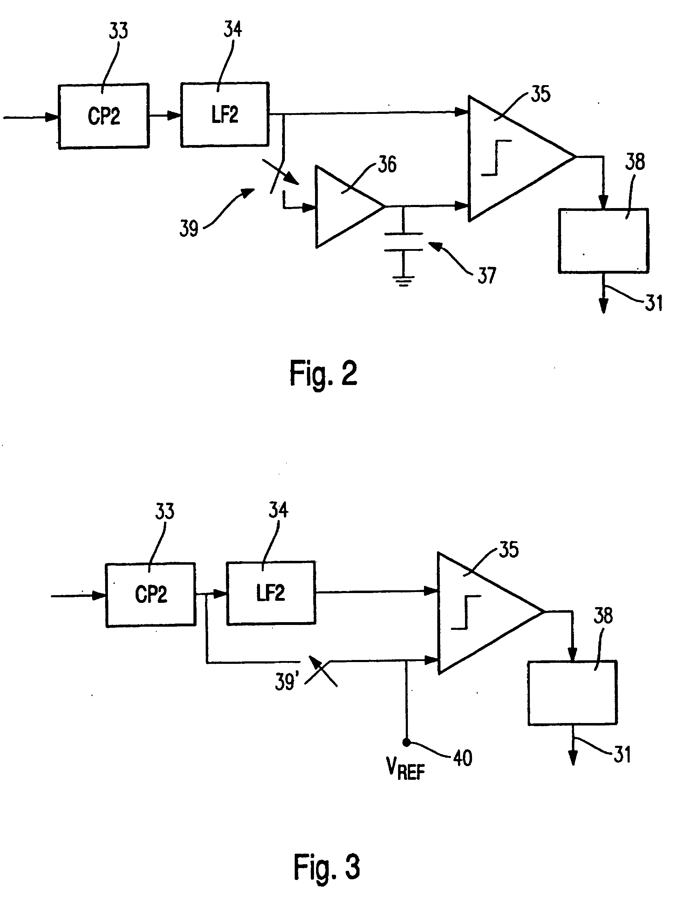

Fig. 2 zeigt ein erstes Ausführungsbeispiel der erfindungsgemäßen Abgleicheinheit 30. Die Abgleicheinheit 30 umfasst eine zweite Ladungspumpe CP2 33 und ein der zweiten Ladungspumpe CP2 nachgeschaltetes zweites Tiefpassfilter LF2 34. Die zweite Ladungspumpe LF2 34 und das zweite Tiefpassfilter 34 realisieren den vorstehend erwähnten Parallelpfad. Der Ausgang des Tiefpassfilters LF2 34 ist einem der Eingänge eines Komparators 35 zugeführt. Der andere Eingang des Komparators 35 steht mit dem Ausgang eines Puffers 36 in Verbindung. Ein Kondensator 37 liegt zwischen dem zweiten Komparatoreingang und Masse. Ein Ausgang des Komparators 35 wird einer Auswerteschaltung 38 zugeleitet, welche das Steuersignal 31 erzeugt.

Die erfindungsgemäße Abgleicheinheit 30 wird in der folgenden Weise zum Abgleichen der Modulationsamplituden eingesetzt:

Zunächst wird die PLL-Schaltung 10 vor dem Sendevorgang auf die gewünschte Kanalmittenfrequenz programmiert. Dies geschieht allein durch Einstellen des entsprechenden Teilerfaktors N beziehungsweise der digitalen Kanalrepräsentation (z.B. einem Kanalwort bei Verwendung eines Fraktional-N Sigma-Delta-Programmieres 20) am Frequenzteiler 18.

Nach der Einstellung der gewünschten Kanalmittenfrequenz wird die PLL-Schaltung 10 eingeschaltet und schwingt auf die Kanalmittenfrequenz ein.

Bei dem Einschwingen der PLL-Schaltung 10 wird das zweite Tiefpassfilter LF2 34 über die zweite Ladungspumpe CP2 33 aufgeladen. Über einen Schalter 39, der während des Einschwingvorgangs geschlossen ist, wird das Ausgangssignal von LF2 34 dem Puffer 36 zugeleitet. Dabei wird der am Ausgang des Puffers 36 angeordnete Kondensator 37 aufgeladen.

Das Aufladen des Kondensators 37 dient der Erzeugung eines Referenzsignals. Nach dem Einschwingen der PLL-Schaltung 10 wird der Schalter 39 geöffnet. Dies bewirkt, dass die durch Aufladung des Kondensators 37 erzeugte Spannung nunmehr als konstante Referenzspannung V_{REF} an dem zweiten Eingang des Komparators 35 anliegt.

Anschließend wird sowohl analog als auch digital für eine bestimmte Dauer eine konstante Modulation (d.h. eine "Gleichspannungs-Testmodulation") aufgeprägt. Durch den bereits erwähnten Amplitudenfehler der analogen Modulation (d.h. durch den fehlerbehafteten analogen Modulationshub im Vergleich zum digitalen Modulationshub) wird sich nun die von dem zweiten Tiefpassfilter LF2 ausgegebene Spannung entsprechend ändern. Die Spannung am Ausgang des zweiten Tiefpassfilters LF2 wird im Komparator 35 mit der Referenzspannung verglichen und das Vergleichsergebnis wird der Auswerteschaltung 38 fortlaufend mitgeteilt. Die Auswerteschaltung 38 wertet das von dem Komparator 35 erhaltene Vergleichssignal aus und erfasst dabei eine Änderung der von dem zweiten Tiefpassfilter LF2 ausgegebenen Spannung (d.h. in der Auswerteschaltung 38 wird das nach dem Einschwingen der PLL aber noch vor dem Anlegen der analogen und digitalen Modulationen erhaltene Komparator-Vergleichssignal mit dem nach dem Anlegen der analogen und digitalen Modulationen erhaltenen Komparator-Vergleichssignal verglichen). Das von der Auswerteschaltung 38 erzeugte Steuersignal 31 bewirkt dann über die Einrichtung 32 eine Änderung der Amplitude des analogen Modulationshubs beziehungsweise des analogen Modulationssignals in der Weise, dass die am Ausgang des zweiten Tiefpassfilters LF2 34 auftretende Spannungsdifferenz zu der im vorhergehenden Schritt (ohne Modulation) erhaltenen Spannung beseitigt wird.

Die Auswertung des von dem Komparator 35 ausgegebenen Signals in der Auswerteschaltung 38 kann beispielsweise in einem iterativen Prozess erfolgen, d.h. es erfolgt ein schrittweiser approximativer Abgleich der analogen Modulationsamplituden mit wechselweiser Aktualisierung des Steuersignals 31 und Bewertung des daraufhin erhaltenen, geänderten Ausgangssignals des Komparators 35. Bei erfolgter Beseitigung der bei Hinzuschalten der analogen und digitalen Modulation aufgetretenen Spannungsänderung am Ausgang des Tiefpassfilters LF2 ist die Anpassung zwischen digitalem und analogem Modulationshub erreicht.

Fig. 3 zeigt ein zweites Ausführungsbeispiel für die Abgleicheinheit 30. Dieselben oder funktionsgleiche Bauteile sind mit denselben Bezugszeichen wie in Fig. 2 bezeichnet. Die Abgleicheinheit 30 umfasst wiederum eine zweite Ladungspumpe CP2 33, ein zweites Tiefpassfilter LF2 34, einen Komparator 35 und eine Auswerteschaltung 38. Bezüglich dieser Komponenten ist er Schaltungsaufbau des zweiten Ausführungsbeispiels identisch mit dem in Fig. 2 dargestellten Schaltungsaufbau des ersten Ausführungsbeispiels. Ferner weist die Schaltung einen Knoten 40 auf, über welchen eine vorgegebene externe, feste Referenzspannung V_{REF} an den zweiten Komparatoreingang anlegbar ist. Die externe Referenzspannung V_{REF} kann ferner über einen Schalter 39' an den Eingang des zweiten Tiefpassfilers LF2 34 angelegt werden.

Die in Fig. 3 dargestellte Schaltung unterscheidet sich im wesentlichen nur dadurch von der in Fig. 2 dargestellten Schaltung, dass die Referenzspannung für den Komparator 35 hier nicht aus dem Einschwingvorgang der PLL abgeleitet sondern extern erzeugt wird. Der Modulationshubabgleich erfolgt in der folgenden Weise:

Entweder vor dem Einschalten der PLL-Schaltung 10 oder bei bereits eingeschalteter und eingeschwungener PLL-Schaltung 10 wird die zweite Ladungspumpe CP2 33 deaktiviert und der Schalter 39' geschlossen. Dies hat zur Folge, dass das zweite Tiefpassfilter LF2 34 allein über die Referenzspannung V_{REF} aufgeladen wird (Precharging), da die zweite Ladungspumpe CP2 33 im deaktivierten Zustand hochohmig ist. Die Auswerteschaltung 30 ist somit in diesem Zustand von der PLL-Schaltung 10 entkoppelt.

Nach dem Aufladen des Tiefpassfilters LF2 34, dem Einstellen der Kanalmittenfrequenz und dem Einschwingvorgang der PLL-Schaltung 10, der die Abgleicheinheit 30 hier unbeeinflusst lässt, wird der Schalter 39' geöffnet. Die am zweiten Eingang des Komparators 35 anliegende Referenzspannung V_{REF} wird dadurch (zumindest für die Dauer des nachfolgenden Abgleichs) fixiert. Anschließend wird die zweite Ladungspumpe CP2 33 aktiviert. Die weitere Vorgehensweise entspricht dem bereits zur Fig. 2 erläuterten Verfahren (Einprägen der konstanten analogen und digitalen Modulationen, Abgleich der dabei am Ausgang des Tiefpassfilters 34 auftretenden Spannungsdifferenz mit Hilfe der Auswerteschaltung 38 und der Einrichtung 32 zur Beeinflussung der Amplitude des analogen Modulationssignals).

Beide Ausführungsbeispiele ermöglichen eine aufwandsarme und stromsparende Erzeugung der am zweiten Komparatoreingang benötigten konstanten Referenzspannung. Im zweiten Ausführungsbeispiel kann als Referenzspannung z.B. die ohnehin vorhandene Versorgungs- oder Bandgap-Spannung verwendet werden. Die Referenzspannung sollte dabei möglichst im Bereich maximaler Empfindlichkeit des Komparators 35 liegen.

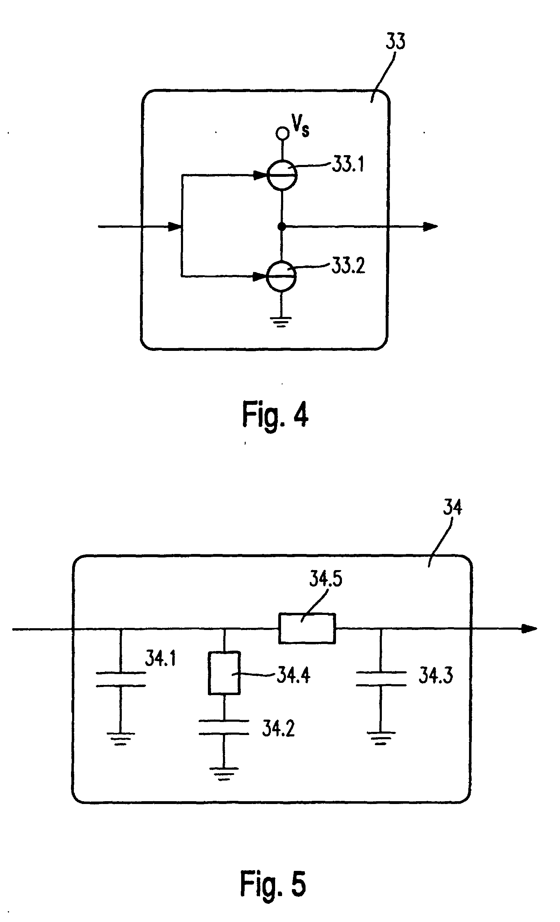

Fig. 4 zeigt eine mögliche Realisierung der zweiten Ladungspumpe CP2 33. Die zweite Ladungspumpe CP2 33 umfasst zwei steuerbare Stromquellen 33.1 und 33.2, die seriell zwischen einer Betriebsspannung Vₛ und Masse liegen. Die beiden steuerbaren Stromquellen 33.1, 33.2 sind üblicherweise Einzeltransistoren oder Mehrtransistor-Schaltungen. Die Steuerung der Stromquellen 33.1, 33.2 erfolgt über ein Eingangssignal, welches im vorliegenden Fall das durch die Regelabweichung in der PLL-Schaltung gegebene Steuersignal 17 ist. Es können zur Ansteuerung der Ladungspumpe auch zwei Steuersignale ("up" und "down"-Signale) vorgesehen sein, die direkt von einem entsprechend aufgebauten Phasendetektor ausgegeben werden. Der Ausgang der hier gezeigten zweiten Ladungspumpe 33 zweigt an der Verbindung zwischen den beiden Stromquellen 33.1 und 33.2 ab.

Fig. 5 zeigt ein Schaltungsbeispiel für das zweite Tiefpassfilter LF2 34. Wie bei dem in Fig. 4 dargestellten Schaltungsbeispiel sind eine Vielzahl anderer Schaltungen verwendbar.

Das Tiefpassfilter 34 umfasst drei Kondensatoren 34.1, 34.2 und 34.3, die - im Fall des Kondensators 34.2 über einen Widerstand 34.4 - über den Filtereingang aufladbar sind. Im Signalweg befindet sich ein Widerstand 34.5.

Zusammenfassend ist festzustellen, dass beide Ausführungsbeispiele bis auf den Gesichtspunkt der Bereitstellung der Referenzspannung V_{REF} weitestgehend vergleichbar sind und ihre gemeinsame Wirkungsweise darauf beruht, dass bei einer Amplitudendifferenz zwischen den beiden Modulationen am Phasendetektor PFD 12 eine Regelabweichung festgestellt wird, welche von der Abgleicheinheit 30 aufgegriffen, geeignet aufbereitet und für den Amplitudenabgleich ausgenutzt wird.

## Patentansprüche

1. Verfahren zum Amplitudenabgleich zwischen einem analogen und einem digitalen Modulationssignal für eine nach dem Prinzip der Zwei-Punkt-Modulation arbeitende PLL-Schaltung (10), wobei das analoge Modulationssignal über einen Summationspunkt (15) eingangsseitig eines spannungsgesteuerten Oszillators (16) in die PLL-Schaltung (10) eingekoppelt wird und das digitale Modulationssignal in einen im Rückführungszweig der PLL-Schaltung (10) angeordneten Frequenzteiler (18) eingeprägt wird, mit den Schritten:
- Einschwingen der PLL-Schaltung (10) auf eine gewünschte Trägerfrequenz ohne Einprägen einer Modulation;
- Einprägen eines analogen Modulationssignals und eines digitalen Modulationssignals in die eingeschwungene PLL-Schaltung (10), wodurch eine PLL-Regelabweichung auftritt;
- Auskoppeln eines für die PLL-Regelabweichung charakteristischen Signals aus der PLL-Schaltung (10); und
- Ändern des Modulationshubs des analogen Modulationssignals in der Weise, dass das für die PLL-Regelabweichung charakteristische Signal den gleichen Wert wie vor dem Einprägen der analogen und digitalen Modulationssignale aufweist.

2. Verfahren nach Anspruch 1,
**gekennzeichnet durch** den Schritt:
- Auskoppeln des für die PLL-Regelabweichung der PLL-Schaltung (10) charakteristischen Signals, welches ein Spannungssignal ist, über eine Ladungspumpe (33) und ein Tiefpassfilter (34) aus der PLL-Schaltung (10).

3. Verfahren nach Anspruch 1,
**gekennzeichnet durch** die Schritte:
- Vergleichen des für die PLL-Regelabweichung charakteristischen Signals mit einem Referenzsignal eines festen Wertes, wobei ein Vergleichssignal erzeugt wird;
- Auswerten des Vergleichssignals vor und nach dem Einprägen der analogen und digitalen Modulation; und
- Ändern des Modulationshubs des analogen Modulationssignals auf der Basis des Auswerteergebnisses.

4. Verfahren nach Anspruch 3,
**dadurch gekennzeichnet, dass** zur Bereitstellung des Referenzsignals
- die PLL-Schaltung (10) im deaktivierten Zustand auf eine gewünschte Kanalmittenfrequenz eingestellt wird;
- die PLL-Schaltung (10) aktiviert wird und dabei einschwingt; und
- beim Einschwingvorgang aus dem für die Regelabweichung der PLL-Schaltung (10) charakteristischen Signal das Referenzsignal (V_{REF}) erzeugt wird.

5. Verfahren nach Anspruch 3,
**dadurch gekennzeichnet, dass**
- ein vorgegebenes externes Referenzsignal (V_{REF}) bereitgestellt wird.

6. PLL-Schaltung, ausgelegt für das Einprägen eines analogen und eines digitalen Modulationssignals nach dem Prinzip der Zwei-Punkt-Modulation, mit
- einem spannungsgesteuerten Oszillator (16), dem eingangsseitig ein Summationspunkt (15) vorgeschaltet ist, über welchen das analoge Modulationssignal in die PLL-Schaltung (10) eingekoppelt wird, und
- einem im Rückführungszweig der PLL-Schaltung (10) angeordneten Frequenzteiler (18), dem das digitale Modulationssignal eingeprägt wird, wobei der PLL-Schaltung (10) eine Abgleicheinrichtung (30, 32) zugeordnet ist, welche umfasst:
- ein Mittel (33, 34) zum Auskoppeln eines für die beim Einprägen des analogen und des digitalen Modulationssignals auftretende PLL-Regelabweichung charakteristischen Signals aus der PLL-Schaltung (10),
- ein Mittel (35, 38) zum Auswerten des charakteristischen Signals, und
- ein Mittel (32) zum Ändern des Modulationshubs des analogen Modulationssignals in Abhängigkeit von dem Auswerteergebnis.

7. PLL-Schaltung nach Anspruch 6,
**dadurch gekennzeichnet, dass**
- das Mittel (33, 34) zum Auskoppeln eines für die PLL-Regelabweichung charakteristischen Signals aus der PLL-Schaltung (10) eine Ladungspumpe (33) und ein der Ladungspumpe nachgeschaltetes Tiefpassfilter (34) umfasst.

8. PLL-Schaltung nach Anspruch 6 oder 7,
**dadurch gekennzeichnet, dass** das Mittel (35, 38) zum Auswerten des charakteristischen Signals umfasst:
-- ein Mittel (35) zum Vergleichen des für die Regelabweichung charakteristischen Signals mit einem Referenzsignal (V_{REF}) eines festen Wertes, wobei ein Vergleichssignal erzeugt wird, und
-- ein Mittel (38) zum Auswerten des Vergleichssignals vor und nach dem Einprägen der analogen und digitalen Modulation.

9. PLL-Schaltung nach Anspruch 8,
**gekennzeichnet durch**
- Schaltmittel (39), derart angeordnet, dass das Mittel zum Auskoppeln (33, 34) des für die PLL-Regelabweichung charakteristischen Signals beim Einschwingvorgang der PLL-Schaltung (10) zur Erzeugung des Referenssignals (V_{REF}) nutzbar ist.

## Claims

1. Method for amplitude trimming between an analogue and a digital modulation signal for a PLL circuit (10) operating on the basis of the principle of two-point modulation, where the analogue modulation signal is injected into the PLL circuit (10) via a summation point (15) on the input side of a voltage-controlled oscillator (16), and the digital modulation signal is impressed into a frequency divider (18) arranged in the feedback path of the PLL circuit (10), having the following steps:
- the PLL circuit (10) is locked onto a desired carrier frequency without any modulation being impressed;
- an analogue modulation signal and a digital modulation signal are impressed into the locked PLL circuit (10), which results in a PLL control error;
- a signal which is characteristic of the PLL control error is tapped from the PLL circuit (10); and
- the modulation swing in the analogue modulation signal is changed such that the signal which is characteristic of the PLL control error has the same value as before the analogue and digital modulation signals were impressed.

2. Method according to Claim 1,
**characterized by** the following step:
- the signal which is characteristic of the PLL control error in the PLL circuit (10), which signal is a voltage signal, is tapped from the PLL circuit (10) via a charge pump (33) and a low-pass filter (34).

3. Method according to Claim 1,
**characterized by** the following steps:
- the signal which is characteristic of the PLL control error is compared with a reference signal having a fixed value, thus producing a comparison signal;
- the comparison signal is evaluated before and after the analogue and digital modulation is impressed; and
- the modulation swing in the analogue modulation signal is changed on the basis of the evaluation result.

4. Method according to Claim 3,
**characterized in that**
the reference signal is provided by
- adjusting the PLL circuit (10) in the deactivated state to a desired channel centre frequency;
- activating the PLL circuit (10) and thereby locking it; and
- producing the reference signal (V_{REF}) from the signal which is characteristic of the control error in the PLL circuit (10) during the locking process.

5. Method according to Claim 3,
**characterized in that**
- a prescribed external reference signal (V_{REF}) is provided.

6. PLL circuit, designed for impressing an analogue and a digital modulation signal on the basis of the principle of two-point modulation, having
- a voltage-controlled oscillator (16) whose input side has a summation point (15) connected upstream of it which is used to inject the analogue modulation signal into the PLL circuit (10), and
- a frequency divider (18) which is arranged in the feedback path in the PLL circuit (10) and on which the digital modulation signal is impressed, the PLL circuit (10) having an associated trimming device (30, 32) which comprises:
- a means (33, 34) for tapping a signal which is characteristic of the PLL control error which arises when the analogue and the digital modulation signal are impressed from the PLL circuit (10),
- a means (35, 38) for evaluating the characteristic signal, and
- a means (32) for changing the modulation swing in the analogue modulation signal on the basis of the evaluation result.

7. PLL circuit according to Claim 6,
**characterized in that**
- the means (33, 34) for tapping a signal which is characteristic of the PLL control error from the PLL circuit (10) comprises a charge pump (33) and a low-pass filter (34) which is connected downstream of the charge pump.

8. PLL circuit according to Claim 6 or 7,
**characterized in that**
the means (35, 38) for evaluating the characteristic signal comprises:
-- a means (35) for comparing the signal which is characteristic of the control error with a reference signal (V_{REF}) having a fixed value, thus producing a comparison signal, and
-- a means (38) for evaluating the comparison signal before and after the analogue and digital modulation is impressed.

9. PLL circuit according to Claim 8,
**characterized by**
- switching means (39) arranged such that the means for tapping (33, 34) the signal which is characteristic of the PLL control error can be used to produce the reference signal (V_{REF}) during the locking process in the PLL circuit (10).

## Revendications

1. Procédé pour l'équilibrage d'amplitude entre un signal de modulation analogique et un signal de modulation numérique pour une boucle à verrouillage de phase PLL (10) travaillant selon le principe de la modulation à deux états, le signal de modulation analogique étant introduit dans la boucle à verrouillage de phase PLL (10) par l'intermédiaire d'un point additionneur (15) côté entrée d'un oscillateur commandé par tension (16) et le signal de modulation numérique étant introduit dans un diviseur de fréquence (18) placé dans la branche de rétroaction de la boucle à verrouillage de phase PLL (10), avec les étapes :
- régime transitoire de la boucle à verrouillage de phase PLL (10) sur une fréquence porteuse souhaitée sans application d'une modulation ;
- introduction d'un signal de modulation analogique et d'un signal de modulation numérique dans la boucle à verrouillage de phase PLL (10) en régime permanent, ce qui fait qu'il apparaît un écart de régulation de PLL ;
- sortie d'un signal, caractéristique de l'écart de régulation de PLL, hors de la boucle à verrouillage de phase PLL (10) ; et
- modification de l'amplitude de modulation du signal de modulation analogique de telle sorte que le signal caractéristique de l'écart de régulation de PLL présente la même valeur qu'avant l'introduction des signaux de modulation analogique et numérique.

2. Procédé selon la revendication 1, **caractérisé par** l'étape :
- sortie du signal caractéristique de l'écart de régulation de PLL de la boucle à verrouillage de phase PLL (10), lequel est un signal de tension, par l'intermédiaire d'une pompe de charge (33) et d'un filtre passe-bas (34), hors de la boucle à verrouillage de phase PLL (10).

3. Procédé selon la revendication 1, **caractérisé par** les étapes :
- comparaison du signal caractéristique de l'écart de régulation de PLL à un signal de référence d'une valeur fixe, un signal de comparaison étant produit ;
- évaluation du signal de comparaison avant et après l'application de la modulation analogique et de la modulation numérique ; et
- modification de l'amplitude de modulation du signal de modulation analogique sur la base du résultat d'évaluation.

4. Procédé selon la revendication 3, **caractérisé par le fait que**, pour fournir le signal de référence,
- la boucle à verrouillage de phase PLL (10) est réglée à l'état désactivé sur une fréquence centrale de canal souhaitée ;
- la boucle à verrouillage de phase PLL (10) est activée et entre donc en régime transitoire ; et
- lors du régime transitoire, le signal de référence (V_{REF}) est produit à partir du signal caractéristique de l'écart de régulation de la boucle à verrouillage de phase PLL (10).

5. Procédé selon la revendication 3, **caractérisé par le fait qu'**un signal de référence (V_{REF}) externe prédéfini est fourni.

6. Boucle à verrouillage de phase PLL, conçue pour l'introduction d'un signal de modulation analogique et d'un signal de modulation numérique selon le principe de la modulation à deux états,
- avec un oscillateur commandé par tension (16) du côté amont duquel est branché côté entrée un point additionneur (15) par l'intermédiaire duquel le signal de modulation analogique est introduit dans la boucle à verrouillage de phase PLL (10), et
- avec un diviseur de fréquence (18) qui est placé dans la branche de rétroaction de la boucle à verrouillage de phase PLL (10) et auquel le signal de modulation numérique est appliqué, un dispositif d'équilibrage (30, 32) étant associé à la boucle à verrouillage de phase PLL (10), lequel comprend :
- un moyen (33, 34) pour sortir de la boucle à verrouillage de phase PLL (10) un signal caractéristique de l'écart de régulation de PLL apparaissant lors de l'application du signal de modulation analogique et du signal de modulation numérique,
- un moyen (35, 38) pour évaluer le signal caractéristique, et
- un moyen (32) pour modifier l'amplitude de modulation du signal de modulation analogique en fonction du résultat d'évaluation.

7. Boucle à verrouillage de phase PLL selon la revendication 6, **caractérisée par le fait que** le moyen (33, 34) pour sortir de la boucle à verrouillage de phase PLL (10) un signal caractéristique de l'écart de régulation de PLL comprend une pompe de charge (33) et un filtre passe-bas (34) branché du côté aval de la pompe de charge.

8. Boucle à verrouillage de phase PLL selon la revendication 6 ou 7, **caractérisée par le fait que** le moyen (35, 38) pour évaluer le signal caractéristique comprend :
- un moyen (35) pour comparer le signal caractéristique de l'écart de régulation à un signal de référence (V_{REF}) d'une valeur fixe, un signal de comparaison étant produit, et
- un moyen (38) pour évaluer le signal de comparaison avant et après l'application de la modulation analogique et de la modulation numérique.

9. Boucle à verrouillage de phase PLL selon la revendication 8, **caractérisée par** des moyens de commutation (39) agencés de telle sorte que le moyen (33, 34) pour sortir le signal caractéristique de l'écart de régulation de PLL est utilisable lors du régime transitoire de la boucle à verrouillage de phase PLL (10) pour la production du signal de référence (V_{REF}).
